# EUROPÄISCHE PATENTSCHRIFT

(11) **EP 0 989 201 B1**
(45) Veröffentlichungstag und Bekanntmachung des Hinweises auf die Patenterteilung: **05.06.2002**
(21) Anmeldenummer: 99117391.5
(22) Anmeldetag: 03.09.1999
(51) Int. Cl.: C23C 14/26

(54) **Verdampferkörper**
Evaporator body
Corps évaporateur

(30) Priorität: 24.09.1998 DE 19843819
(43) Veröffentlichungstag der Anmeldung: 29.03.2000
(73) Patentinhaber: Applied Films GmbH & Co. KG, 63755 Alzenau (DE)
(72) Erfinder: Klemm, Günter, 63667 Nidda (DE); Eller, Detelf, 63546 Hammersbach (DE); Achtner, Wolfgang, 63477 Maintal 1 (DE); Vogt, Thomas, 63538 Grosskrotzenburg (DE)
(74) Vertreter: Schlagwein, Udo, Dipl.-Ing.

(56) Entgegenhaltungen:
- DE-A- 4 016 225
- DE-C- 974 136

## Beschreibung

Die Erfindung betrifft einen Verdampferkörper für einen Verdampfer einer Vakuum-Bedampfungsanlage, welcher aus zumindest zwei in einer Reihe hintereinander durch eine Verbindung an einer Stirnseite elektrisch leitend miteinander gekoppelten Verdampferschiffchen besteht. Ein Verdampferkörper der vorstehenden Art ist in dem deutschen Patent 40 16 225 beschrieben.

Bei großen Verdampfern ist es aus Fertigungsgründen nicht mehr möglich, Verdampferschiffchen einteilig in der erforderlichen Länge herzustellen. Deshalb ist es in solchen Fällen erforderlich, zwei oder sogar mehrere Verdampferschiffchen in einer Reihe hintereinander anzuordnen und dabei an den aneinanderstoßenden Stirnseiten miteinander zu verbinden. Diese Verbindung erfolgt bei den Verdampferschiffchen nach der genannten DE 40 16 225 C2 dadurch, dass die aneinanderstoßenden Stirnseiten jeweils eine halbschalenförmige Ausnehmung aufweisen und diese Ausnehmungen über eine beiden Verdampferschiffchen gemeinsame, horizontal ausgerichtete Rolle greifen. Die Rolle besteht dabei aus dem gleichen Material wie die beiden Verdampferschiffchen.

Über die Verbindung zwischen den Verdampferschiffchen muss beim Arbeiten des Verdampfers der gesamte, zum Beheizen der beiden Verdampferschiffchen erforderliche Strom fließen. Deshalb müssen die Verdampferschiffchen an den Berührungsflächen fest aneinander liegen. Das ist jedoch bei den bekannten Verdampferschiffchen nur unvollkommen zu verwirklichen, weil infolge der Zylinderflächen sich nur in der Mitte eine hohe Spannkraft erreichen lässt, diese jedoch nach oben und unten hin entsprechend der Krümmung der Zylinderflächen abnimmt. Ein weiterer Nachteil der bekannten Verbindung liegt darin, dass diese ein Gelenk bildet. Die miteinander verbundenen Verdampferschiffchen sollen sich jedoch möglichst geradlinig erstrecken. Das wird im eingebauten Zustand dadurch erreicht, dass jeweils ein Verdampferschiffchen zwischen den als Stützen ausgeführten, elektrischen Zuleitungen von einer weiteren Stütze getragen wird. Die gelenkige Verbindung der beiden Verdampferschiffchen macht jedoch Schwierigkeiten bei der Handhabung der Verdampferschiffchen während der Montage und Demontage.

Der Erfindung liegt das Problem zugrunde, einen Verdampferkörper mit zumindest zwei Verdampferschiffchen zu entwickeln, bei dem die Verbindung der Verdampferschiffchen möglichst einfach gestaltet ist und zu einer starren, unveränderlichen Ausrichtung der Verdampferschiffchen zueinander führt.

Dieses Problem wird erfindungsgemäß dadurch gelöst, dass die Verbindung der Verdampferschiffchen durch einen sich verjüngenden, nicht durch kreisbogenförmige Flächen begrenzten Vorsprung an einer Stirnseite eines Verdampferschiffchens und eine entsprechende Ausnehmung in der Stirnseite des angrenzenden Verdampferschiffchen gebildet ist.

Durch diese Gestaltung ist zwischen den Verdampferschiffchen zur Erzeugung der Verbindung kein zusätzliches Verbindungsteil erforderlich. Dadurch dass die Verdampferschiffchen stirnseitig mit dem Vorsprung und der Ausnehmung ineinandergreifen, wird eine starre, zu einer festgelegten Ausrichtung führende Verbindung erreicht, die zugleich einen zuverlässigen Stromfluss ermöglicht. Da der Vorsprung keine kreisbogenförmigen Flächen hat, entsteht statt einer gelenkigen Verbindung eine starre Verbindung, so dass die Ausrichtung der Verdampferschiffchen zueinander durch die Verbindung festgelegt wird.

Besonders vorteilhaft ist es, wenn der Vorsprung als durch eine obere und untere Schrägfläche gebildeter, sich horizontal erstreckender Keil gestaltet ist und die Ausnehmung entsprechend durch zwei von oben und von unten schräg in die Stirnfläche führende Flächen begrenzt ist. Durch diese Gestaltung wird Spiel im Bereich der Verbindung vermieden. Weiterhin lässt sich erreichen, dass über den gesamten Verbindungsbereich ausreichend hohe, axiale Kräfte übertragen werden können, was für eine zuverlässige Anlage der Teile und dadurch zu einem geringen elektrischen Übergangswiderstand führt.

Zur weiteren Verbesserung des Stromflusses durch den Verbindungsbereich trägt es bei, wenn zwischen dem Versprung des einen Verdampferschiffchens und der Ausnehmung des anderen Verdampferschiffchens eine Graphitfolie angeordnet ist.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt in
- Fig.1: einen Verbindungsbereich zweier einen Verdampferkörper bildender Verdampferschiffchen,
- Fig.2: eine Ansicht einer Stirnseite eines Verdampferschiffchens,
- Fig.3: eine Seitenansicht eines kompletten Verdampferschiffchens.

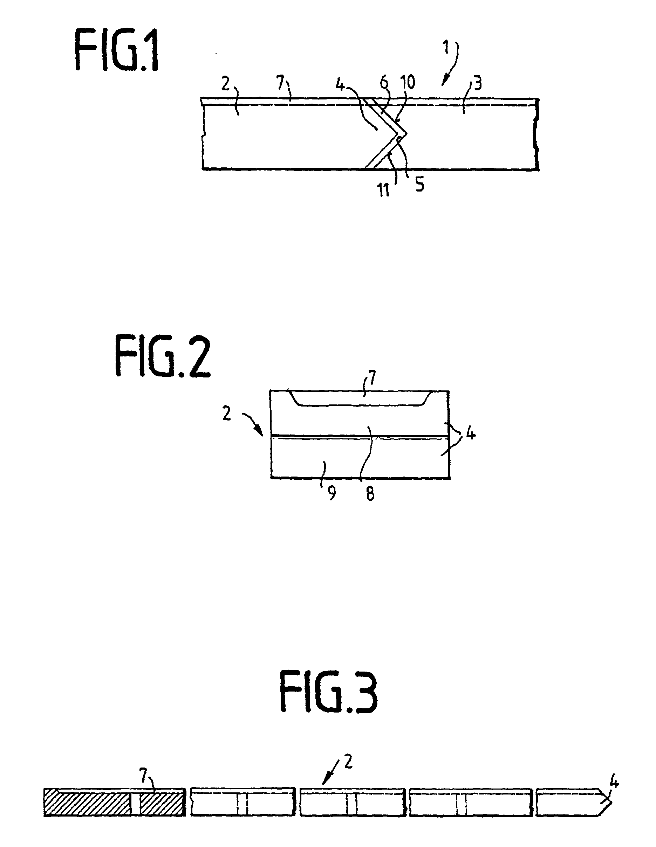

Die Figur 1 zeigt von einem Verdampferkörper 1 Endbereiche zweier stirnseitig miteinander verbundener Verdampferschiffchen 2 und 3. Diese Verbindung erfolgt dadurch, dass das Verdampferschiffchen 2 mit einem Vorsprung 4 in eine entsprechende Ausnehmung 5 des Verdampferschiffchens 3 greift. Zwischen dem Vorsprung 4 und der Ausnehmung 5 ist bei diesem Ausführungsbeispiel eine Graphitfolie 6 angeordnet. In der oberen Seite des Verdampferkörpers 1 ist eine Aushöhlung 7 vorhanden, welche über den Verbindungsbereich beider Verdampferschiffchen 2, 3 hinweg führt und in der das zu verdampfende Metall eingebracht wird. Der Verdampferkörper 1 hat also eine einzige, durchgehende Aushöhlung 7.

Die Figur 2 zeigt einen Blick von rechts auf das Verdampferschiffchen 2. In dieser Figur 2 wurden zwei Schrägflächen 8, 9 positioniert, welche den Vorsprung 4 begrenzen, so dass dieser einen sich horizontal erstreckenden Keil bildet. Wie in Figur 1 zu sehen ist, hat die Keilspitze einen Winkel von etwa 90°. In der Praxis muss diese abgeflacht sein, damit die Keilflächen 8, 9 gegen die entsprechenden, in Figur 1 positionierten Flächen 10, 11 der Ausnehmung 5 anliegen.

Die Figur 3 zeigt das Verdampferschiffchen 2 als Ganzes. Zu sehen sind wiederum der keilförmige Vorsprung 4 und die Aushöhlung 7 in der Oberseite des Verdampferschiffchens 2.

### Bezugszeichenliste

- 1: Verdampferkörper
- 2: Verdampferschiffchen
- 3: Verdampferschiffchen
- 4: Vorsprung
- 5: Ausnehmung

- 6: Graphitfolie
- 7: Aushöhlung
- 8: Schrägfläche
- 9: Schrägfläche
- 10: Fläche

- 11: Fläche

## Patentansprüche

1. Verdampferkörper für einen Verdampfer einer Vakuum-Bedampfungsanlage, welcher aus zumindest zwei in einer Reihe hintereinander durch eine Verbindung an einer Stirnseite elektrisch leitend miteinander gekoppelten Verdampferschiffchen besteht, **dadurch gekennzeichnet, dass** die Verbindung der Verdampferschiffchen (2, 3) durch einen sich verjüngenden, nicht durch kreisbogenförmige Flächen begrenzten Vorsprung (4) an einer Stirnseite eines Verdampferschiffchens (2) und eine entsprechende Ausnehmung (5) in der Stirnseite des angrenzenden Verdampferschiffchen (3) gebildet ist.

2. Verdampferkörper nach Anspruch 1, **dadurch gekennzeichnet, dass** der Vorsprung (4) als durch eine obere Schrägfläche (8) und untere Schrägfläche (9) gebildeter, sich horizontal erstreckender Keil gestaltet ist und die Ausnehmung (5) entsprechend durch zwei von oben und von unten schräg in die Stirnfläche führende Flächen (10, 11) begrenzt ist.

3. Verdampferkörper nach den Ansprüchen 1 oder 2, **dadurch gekennzeichnet, dass** zwischen dem Versprung (4) des einen Verdampferschiffchens (2) und der Ausnehmung (5) des anderen Verdampferschiffchens (3) eine Graphitfolie (6) angeordnet ist.

## Claims

1. Evaporator body for an evaporator in a vacuum vaporisation plant, which evaporator body consists of at least two evaporator boats which are coupled to one another in a row, one behind the other, in an electrically conductive manner by a connection at an end face, **characterised in that** the connection between the evaporator boats (2, 3) is formed by a tapering projection (4), which is not delimited by arcuate faces, on an end face of an evaporator boat (2), and a corresponding recess (5) in the end face of the adjoining evaporator boat (3).

2. Evaporator body according to claim 1, **characterised in that** the projection (4) is configured as a horizontally extending wedge formed by an upper oblique face (8) and a lower oblique face (9), and the recess (5) is delimited in a corresponding manner by two faces (10, 11) which lead obliquely into the end face from above and below.

3. Evaporator body according to claims 1 or 2, **characterised in that** a graphite film (6) is disposed between the projection (4) on one evaporator boat (2) and the recess (5) in the other evaporator boat (3).

## Revendications

1. Corps évaporateur pour un évaporateur d'un appareil pour la métallisation sous vide, qui comporte au moins deux nacelles évaporatoires l'une derrière l'autre en une rangée couplées l'une avec l'autre par un raccord sur une face frontale par conduction électrique, **caractérisé en ce que** le raccord des nacelles évaporatoires (2,3) est constitué d'une partie en saillie (4) se rétrécissant, non limitée par des surfaces en forme d'arc de cercle sur une face frontale d'une nacelle évaporatoire (2) et d'un évidemment (5) correspondant dans la face frontale de la nacelle évaporatoire (3).

2. Corps évaporateur selon la revendication 1, **caractérisé en ce que** la partie en saillie (4) est constituée d'un coin s'étendant horizontalement formé d'une surface oblique supérieure (8) et d'une surface oblique inférieure (7) et l'évidement (5) correspondant est limité par deux plans (10,11) se dirigeant dans le plan frontal obliquement du haut vers le bas.

3. Corps évaporateur selon les revendications 1 ou 2, **caractérisé en ce qu'**entre la partie en saillie (4) d'une nacelle évaporatoire (2) et l'évidemment (5) de l'autre nacelle évaporatoire (3) est placé une feuille de graphite (6).
